# EUROPEAN PATENT APPLICATION

(11) **EP 1 310 582 A1**
(43) Date of publication of application: **14.05.2003**
(21) Application number: 02257669.8
(22) Date of filing: 06.11.2002
(51) Int. Cl.: C25D 3/38, H01L 21/768

(54) **Process for electrolytic copper plating**

(30) Priority: 07.11.2001 JP 2001341976
(71) Applicant: Shipley Company LLC, Marlborough, MA 01752 (US)
(72) Inventor: Tsuchida, Hideki, Hasuda-shi, Saitama, 349-0127 (JP); Kusaka, Masaru, Kitaadachi-gun, Saitama, 362-0806 (JP); Hayashi, Shinjiro, Saitama-shi, Saitama 330-0023 (JP); Tsukagoshi, Satoru, Kohnosu-shi, Saitama 365-0064 (JP)
(74) Representative: Kent, Venetia Katherine

(57) **Abstract**

A process for electrolytic copper plating, that is suitable for the formation of filled vias without compromising the brightness of the deposit is provided. In this process, copper electroplating is carried out in the presence of a transition metal oxide.

## Description

### Background of the Invention

The present invention relates generally to a process for electrolytic copper plating. In particular, the present invention relates to an electrolytic copper plating process and bath containing a transition metal oxide.

In recent years, improvements in the density and thinness of printed wiring boards has been desired in response to improved performance and decreased size of electronic devices such as personal computers. A means that has been used in order to satisfy these types of demands has been the use of multilayer printed wiring boards (build-up printed wiring boards) that are manufactured by forming a pattern on each layer, and then laminating the next layer to the patterned layer.

With this type of build-up printed wiring board, methods have been developed whereby the effective surface area of the printed wiring boards is increased. This allows adequate electrical connections to be made with MVHs (micro via holes) that are of smaller diameter than possible with conventional plating of only the inner wall surfaces of the MVHs. By such methods, referred to as "via filling", all of the MVHs can be filled with a conductor, thereby forming electrical connections between adjacent layers in build-up printed wiring boards, and thereby decreasing the size and increasing density of printed wiring boards.

Examples of via filling methods that have been disclosed include methods wherein the MVHs are filled with conductive paste using a printing method, methods wherein only the conductor layers on the bottom surfaces of the MVHs are activated, followed by selective electroless copper plating to perform filling, and methods wherein electrolytic copper plating is carried out.

However, because conductive paste is a mixture of copper and organic material, it has a lower conductivity relative to metallic copper, and so providing sufficient electrical connections with small-size MVHs is difficult with such pastes. This method is not effective in decreasing the size and increasing the density of printed wiring boards. In addition, filling methods that employ printing processes require that a viscous paste be used in order to fill holes that are small in diameter and do not pass through (i.e. not through-holes). However, due to the viscosity of the paste, it is difficult to completely fill these holes without a space or void remaining. Methods that involve electroless copper plating are superior to conductive paste methods in that the MVH packing material is a metallic copper deposit that has high conductivity, but the deposition rate of the copper metal is slow. These methods thus have problems with productivity. When general high-speed electroless copper plating baths have been employed, the deposition rate for the plating films has been about 3 µm/hr, but when such baths are used in order to fill typical 100 µm deep, 100 µm wide MVHs with copper, 30 hr or more is required. This is thus a serious disadvantage in terms of productivity.

In contrast, electrolytic copper plating has a plated film deposition rate of 10 to 50 µm/hr, and thus can provide a significant time decrease relative to electroless copper plating. There has been the expectation that such methods would be applied in electrolytic copper plating of MVHs. However, when copper is deposited over all MVH surfaces, it is necessary for the deposition rate near the bottoms of the MVHs to be more rapid than the deposition rate at the MVH openings so that the MVH interiors can be filled with copper without void formation. When the deposition rate near the bottom of the holes is equivalent or slower relative to the deposition rate at the openings, the MVHs will not be filled, or the openings will be covered prior to complete filling of the MVHs with copper. As a result, gaps or voids will remain in the micro via holes, and these methods thus turn out to be inappropriate for practical use.

In the past, electrolytic copper plating baths comprising special compounds having sulfur atoms have been used in order to accelerate deposition rates near the bottom surfaces of the MVHs. In general, the electrolysis conditions have involved direct-current electrolysis carried out using a soluble positive electrode such as a phosphorus-containing copper electrode. However, although good MVH filling performance is exhibited with such methods immediately after production of the bath, the electrolytic copper plating bath destabilizes over time. As a result, clumps are formed when producing electrolytic copper plating layers a certain period of time after production of the bath, leading to degradation of external appearance, and problems with uneven via filling. The inventors of the present invention carried out research concerning these problems, and determined that it is the decomposition products of the sulfur-containing compounds that cause these problems, as described below. The present invention is thus based on an oxidation reaction carried out via titanium oxide, which is used as a method for decreasing amounts of these decomposition products.

### Summary of the Invention

The present invention was developed in light of the above state of affairs, and offers a process for electrolytic copper plating that is appropriate for the formation of filled vias without degradation in external appearance of the plated copper by means of utilizing the photocatalytic capacity of a transition metal oxide, such as titanium oxide. Thus, the present invention offers a process for electrolytic copper plating, wherein plating is carried out in the presence of titanium oxide.

The present invention offers a process for electrolytic copper plating wherein plating is carried out in the presence of titanium oxide using a plating solution including a compound having the structure -X-S-Y-, wherein X and Y are each individually selected from hydrogen, carbon, sulfur, nitrogen and oxygen atoms, and X and Y can be the same only when they are carbon atoms.

In addition, in the present invention, the substrate that is used for electrolytic copper plating is a typical printed wiring board or wafer, and in particular, is a substrate material that has through holes or via holes.

The present invention also offers a composite material obtained by the plating method of the present invention.

### Brief Description of the Drawing

Fig. 1 is a schematic diagram of a via cross-section after copper plating according to the present invention.
Figs. 2A and 2B are schematic diagrams of via cross-sections after copper plating according to conventional processes.

### Detailed Description of the Invention

Any transition metal oxide may be used in the present invention, provided it has photocatalytic capacity. Preferably, the transition metal oxide is a titanium oxide. The preferred titanium oxide is titanium dioxide. The titanium oxide may have a variety of forms including, without limitation, rutile-form, anatase form or amorphous form. The crystal grain diameter and particle size of the transition metal oxide particles can be freely selected. In particular, materials that manifest photocatalytic activity when irradiated with ultraviolet lightor visible light are appropriate for use in the present invention. As used herein, the term "photocatalytic capacity" refers to the oxidative capacity of a transition metal oxide, such as titanium oxide, which is manifested by means of ultraviolet light or visible light.

Titanium oxide can be introduced in the form of a powder into the copper electroplating solution, but it is preferable to use the titanium oxide in the form of a molding, such as granules, as a filter, as beads, or the titanium oxide can be supported by or coated on an appropriate substrate material. Such substrate material can be any desired material, and materials of various shapes can be used, including sheets, spheres, rods, wires or mesh moldings, as well as porous materials. Methods for manufacturing the above moldings are well known, and include supporting or coating methods, any of which may be used. A material produced by forming a titanium dioxide layer on the surface of a plate or mesh composed of titanium is preferably used.

The photocatalytic capacity of the titanium oxide is typically manifested by irradiation with ultraviolet lightor visible light. The ultraviolet light source can be sunlight or artificial light. Examples of artificial light sources include, without limitation, various types of ultraviolet lamps such as low-pressure, medium-pressure and high-pressure ultraviolet lamps. The ultraviolet light can be used as-is, or filtered prior to irradiation. Visible light can be supplied to the plating bath in sufficient quantity by irradiating the bath with ambient light or artificial light.

The light source is situated so that a quantity of light sufficient to manifest photocatalytic capacity impinges upon the titanium oxide. The amount of ultraviolet or visible light irradiation sufficient to manifest photocatalytic activity can be readily determined by a person skilled in the art. The light source can be situated outside the plating bath, but it is preferable for the lamp to be situated inside the plating bath.

In the present electrolytic plating method, the plating solution contains a compound having the structure -X-S-Y-. X and Y are each individually selected from hydrogen, carbon, nitrogen, sulfur and oxygen. In this specification, the above compound will be referred to as a "sulfur-containing compound" for purposes of abbreviation. Preferably, X and Y are each individually selected from hydrogen, carbon, nitrogen and sulfur. More preferably, X and Y are each individually selected from hydrogen, carbon and sulfur. X and Y may be the same when they are carbon atoms. X and Y may each be substituted

The above formula indicates that the S atom has an atomic valence of 2. However, this does not mean that X and Y atoms have atomic valences of 2. The X and Y denote atoms that can bond with any other atoms depending on the atomic valence. For example, when X is hydrogen, the compound has the structure: H-S-Y-.

In particular, the sulfur-containing compound has sulfonic acid groups or alkali metal salts of sulfonic acidgroups. One or more sulfonic acid groups or alkali metal salt groups can be present in the molecule. More particularly, the sulfur-containing compound has the structure -S-CH₂O-R-SO₃M. Event more particularly, the sulfur-containing compound has the structure -S-R-SO₃M. In the above formulae, M denotes a hydrogen or an alkali metal, and R denotes an alkyl group having 3 to 8 carbonatoms. It is additionally desirable for the sulfur-containing compound to have one of the structures (1)-(8) indicated below.

(1) M-SO₃-(CH₂)ₐ-S-(CH₂)_{b}-SO₃-M;

(2) M-SO₃-(CH₂)ₐ-O-CH₂-S-CH₂-O-(CH₂)_{b}-SO₃-M;

(3) M-SO₃-(CH₂)ₐ-S-S-(CH₂)_{b}-SO₃-M;

(4) M-SO₃-(CH₂)ₐ-O-CH₂-S-S-CH₂-O-(CH₂)_{b}-SO₃-M;

(5) M-SO₃-(CH₂)ₐ-S-C-(=S)-S-(CH₂)_{b}-SO₃-M;

(6) M-SO₃-(CH₂)ₐ-O-CH₂-S-C(=S)-S-CH₂-O-(CH₂)_{b}-SO₃-M;

In structures (1)-(6), a and b are integers of 3 to 8, and M denotes hydrogen or an alkali metal.

(7) A-S-(CH₂)ₐ-SO₃-M;

and

(8) A-S-CH₂-O-(CH₂)ₐ-SO₃-M

In structures (7) and (8), a is an integer of 3 to 8; M is hydrogen or an alkali metal; and A is hydrogen, C₁₋₁₀ alkyl group, aryl group, a chain-form or cyclic amine compound containing 1 to 6 nitrogen atoms, 1 to 20 carbon atoms and multiple hydrogen atoms, or a heterocyclic compound containing 1 to 2 sulfur atoms, 1 to 6 nitrogen atoms, 1 to 20 carbon atoms and numerous hydrogen atoms.

The sulfur-containing compound is generally used as a brightening agent, but cases where the compound is used with other objectives are within the scope of the present invention. A single sulfur-containing compound or mixtures of sulfur-containing compounds may be used.

When the sulfur-containing compound is a brightening agent, it may be used in an amount of, for example, 0.1 to 100 mg/L, with 0.5 to 10 mg/L being preferred. When the sulfur-containing compound is used with objectives other than those related to brightening agents, the preferred range for the used amount thereof can be selected appropriately by persons skilled in the art.

The inventors of the present invention et al. discovered that degradation in the appearance of plated copper films and in via filling capacity using electrolytic copper plating solutions is caused by an increase in -X-S or -Y-S compound decomposition product generated by breakdown of the aforementioned sulfur-containing compound, -X-S-Y-. IFor example, when the sulfur-containing compounds have the structure (1) M-SO₃-(CH₂)ₐ-S-(CH₂)_{b}-SO₃-M, the decomposition products M-SO₃-(CH₃)ₐ-S or S-(CH₂)_{b}-SO₃-M can be envisioned, but these products can also be represented as-X-S⁻ and -Y-S⁻ respectively. In this specification, the decomposition products of the sulfur-containing compounds are referred to as "-X-S" for purposes of convenience.

In addition, the -X-S⁻ compound contained in the electrolytic copper plating bath can be a compound having a structure wherein the other part of the molecule does not decompose, or produced by cleavage of one of the X-S or S-Y bonds of the sulfur-containing compound -X-S-Y-, or can be a compound wherein said decomposition product maintains the X-S structure, or the part bonded to the X also decomposes, or various mixtures of these compounds.

The concentration of compound having the -X-S⁻ structure, which is the decomposition product of the sulfur-containing compound, can be measured by any conventional method. Suitable methods include, but are not limited to, high-performance liquid chromatography. When high-performance liquid chromatography is used, the plating bath can be subjected directly to high-performance liquid chromatography, or when contaminants are present that impede measurement, the contaminants can be removed by a treatment, and said chromatographic analysis can then be carried out.

When a single type of-X-S⁻ compound is present, the concentration of such compound should correspond to the concentration of the compound having -X-S structures, and when a mixture of compounds of the structure -X-S are present, the total concentration of the various compounds corresponds to the concentration of the compound having -X-S⁻ structures.

In addition, the -X-S⁻ compound in the electrolytic plating bath ordinarily is present as a counter ion with respect to a cation such as a metal ion or hydronium ion. Thus, in the present invention, compounds with -X-S-H structures are also included among the -X-S compounds when not specifically stated otherwise.

While not intending to be bound by theory, the mechanism whereby the compound having an -X-S⁻ structure is produced when, for example, a phosphorus-containing copper or other such soluble anode is used, is thought to involve a reaction between the sulfur-containing compound and the soluble anode during the electrolysis stoppage period. It is thought that the S-X or S-Y single bond of the sulfur-containing compound is cleaved to generate a compound having the -X-S structure. In addition, during electroplating, the sulfur-containing compound is thought to accept electrons at the cathode, thus cleaving the S-X or S-Y single bond and generating compound having the -X-S⁻ structure. Moreover, electrons released by the conversion of Cu to Cu²⁺ at the soluble anode are thought to be taken up, with the aforementioned sulfur-containing compound producing an -X-S structure.

Again, while not intending to be bound by theory, the detrimental influence of a compound having an -X-S⁻ structure on electrolytic plating is thought to result from bonding between said compound and metal ions such as Cu⁺ or Cu²⁺ ions. When this compound is present, the deposited metal forms clumps, and thus a metal layer with inferior adhesion and heat resistance is produced. In addition, it is thought that these compounds also degrade the appearance of the resulting deposit, such as providing inferior brightness. When forming filled vias as well, it is thought that the bonded compound formed from the aforementioned decomposition product and metal ions causes insufficient via filling by decreasing the metal deposition rate near the bottoms of the vias to values that are equal to or less than the metal deposition rates at the via openings. It is thought that these compounds thus cause problems with filling of the vias due to the presence of residual voids, depending on factors such as via shape.

In the present invention, the concentration of compound having an -X-S structure in the electrolytic plating bath is preferably maintained at 2.0 µmol/L or less, from the standpoint of maintaining the brightness of the deposit. From the standpoint of producing a bright deposit, 1.0 µmol/L or below is preferable. It is more preferable that the concentration of such compound is 0.5 µmol/L or less. From the standpoint of improving via filling properties, it is desirable for the concentration of compound having an -X-S⁻ structure to be maintained at 0.15 µmol/L or below, with 0.1 µmol/L or below being preferred.

A wide variety of electrolytic copper plating baths may be used in the present invention. Examples of such baths include, but are not limited to, copper sulfate plating baths, copper cyanide plating baths, copper pyrophosphate plating baths and other such solutions. Preferably, the electrolytic copper plating bath is a copper sulfate plating bath. By way of example, a copper sulfate plating solution is described below. Other compositions and components of the plating bath can be used in ranges that would be readily determined by persons skilled in the art, based on the literature and descriptions regarding copper sulfate plating solutions described below. Appropriate modifications in composition, concentration and added amount of additives can be made to the base copper electroplating bath composition, provided that the objectives of the present invention can still be attained.

Conventional copper sulfate plating solutions are aqueous solutions having a base composition comprising sulfuric acid, copper sulfate and a water-soluble source of chloride ions compound in addition to the above-described sulfur-containing compound. There are no particular restrictions on the base composition of this plating bath

The sulfuric acid concentration in the copper sulfate plating solution is typically 30 to 400 g/L, with 170 to 210 g/L being preferred. While a sulfuric acid concentration of less than 30 g/L may be used, it may be difficult to pass electricity into the plating bath due to the decrease in conductivity of the plating bath. If the concentration of sulfuric acid is too high, precipitation of copper sulfate may occur.

The concentration of copper sulfate in copper sulfate plating baths is typically 20 to 250 g/L, with 60 to 180 g/L being preferred. While a copper sulfate concentration of less than 20 g/L may be used, the supply of copper ions may be insufficient, and it may not be possible to deposit an appropriate copper film. While a concentration of copper sulfate of greater than 250 g/L may be used, it may be difficult to dissolve in such a high concentration

There are no particular restrictions on the water-soluble source of chloride ions compound contained in the copper sulfate plating bath, provided that the compound provides chloride ions to the copper sulfate plating solution. Examples of said water-soluble chloride ion source compound include, without limitation, hydrochloric acid, sodium chloride, potassium chloride and ammonium chloride. A single water-soluble chloride ion source compound can be used, or mixtures of two or more types may be used. The concentration of the water-soluble chloride ion source compound, in terms of chloride ions, is typically 10 to 200 mg/L, with 30 to 80 mg/L being preferred. If the chloride ion concentration is too low, such as less than 10 mg/L, it may be difficult for the brightening agent, surfactant or other such compounds to act properly.

Surfactants can be used in the present electrolytic copper plating solution. Any conventional surfactants used as additives in electrolytic copper plating solutions may be used in the present invention. Examples of preferred surfactants are those having structures (9)-(13), but are not restricted to these.

(9) HO-(CH₂-CH₂-O)ₐ-H

(in the formula, a is an integer of 5-500);

(10) HO-(CH₂-CH(CH₃)-O)ₐ-H

(in the formula, a is an integer of 5-200);

(11) HO-(CH₂-CH₂-O)ₐ-(CH₂-CH(CH₃)-O)_{b}-(CH₂-CH₂-O)_{c}-H

(in the formula, a and c are integers, a+c = 5-250, and b is an integer of 1-100);

(12) -(NH₂CH₂CH₂)n-

(in the formula, n is 5-500); and 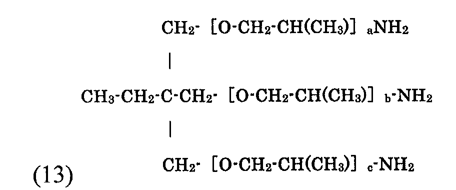 (in the formula, a, b and c are integers of 5-200).

A single surfactant may be used in the present invention or a mixture of surfactants may be used. The surfactant is typically present in an amount of 0.05 to 10 g/L, with 0.1 to 5 g/L being preferred. The surfactant concentration may be less than 0.05 g/L, however, pinholes may be produced in the deposited copper film due to insufficient wetting effects

Suitable substrates used in the present invention are any that can withstand the conditions of the electrolytic copper plating process. The substrate material may be of any material or shape, provided that a copper layer can be electrodeposited thereupon. Examples of suitable substrates include, but are not limited to, resins, ceramics and metals. For example, printed wiring boards are suitable substrate materials composed of resins, and semiconductor wafers are suitable substrate materials composed of ceramics. Examples of metals include silicon such as a silicon wafer, but are not restricted to silicon. The present electrolytic plating method is particularly superior regarding via hole filling. Preferred substrate materials include substrate materials having through holes and via holes. Printed wiring boards or wafers having through holes and/or via holes are preferred.

Examples of reins that can be used in the substrate material include high-density polyethylene, medium-density polyethylene, branched low-density polyethylene, linear low-density polyethylene, ultra-high molecular weight polyethylene and other polyethylene resins, polypropylene resin, polybutadiene, polybutene resin, polybutylene resin, polystyrene resin and other polyolefin resins; polyvinyl chloride resin, polyvinylidene chloride resin, polyvinylidene chloride-vinyl chloride copolymer resin, polyethylene chloride, polypropylene chloride, tetrafluoroethylene and other halogenated resins; AS resin; ABS resin; MBS resin; polyvinyl alcohol resin; polymethyl acrylate and other polyacrylic acid ester resin; polymethyl methacrylate and other polymethacrylic acid ester resins; methyl methacrylate-styrene copolymer resin; maleic anhydride-styrene copolymer resin; polyvinyl acetate resin; cellulose propionate resin, cellulose acetate resin and other cellulose resins; epoxy resin; polyimide resin; nylon and other polyamide resins; polyamidoimide resin; polyarylate resin; polyether imide resin; polyether ether ketone resin; polyethylene oxide resin; PET resin and various other types of polyester resins; polycarbonate resin; polysulfone resin; polyvinyl ether resin; polyvinyl butyral resin; polyphenylene oxide and other polyphenylene ether resins; polyphenylene sulfide resin; polybutylene terephthalate resin; polymethyl pentene resin; polyacetal resin; vinyl chloride-vinyl acetate copolymer; ethylene-vinyl acetate copolymer; ethylene-vinyl chloride copolymer; and other such resins; as well as copolymers and blends thereof and other thermoplastic resins. Other examples include epoxy resin; xylene resin; guanamine resin; diallylphthalate resin; vinyl ester resin; phenol resin; unsaturated polyester resin; furan resin; polyimide resin; polyurethane resin; maleic acid resin; melamine resin; urea resin; and other thermosetting resins, and mixtures thereof. Examples are not restricted to these substances. Examples of preferred resins include epoxy resin, polyimide resin, vinyl resin, phenol resin, nylon resin, polyphenylene ether resin, polypropylene resin, fluorine-system resin and ABS resin, with additionally desirable resins being epoxy resin, polyimide resin, polyphenylene ether resin, fluorine-based resin and ABS resin, and even more desirable resins being epoxy resin and polyimide resin. The resin substrate material can be composed of an individual resin or multiple resins, and the material can also be a composite formed by the lamination or coating of resins on another substrate material. The resin substrate materials that can be used in the present invention are not restricted to resin moldings, as composite materials can be used produced by inserting reinforcing materials such as glass fiber strengthening members into resins. Alternatively, a coating composed of resin can be formed on a substrate material composed of various types of elements such as ceramic, glass and silicon or other metals.

Examples of ceramics that can be used as substrate materials include alumina (Al₂O₃), steatite (MgO·SiO₂), forsterite (2MgO·SiO₂), mullite (3Al₂O₃·2SiO₂), magnesia (MgO), spinel (MgO·Al₂O₃), beryllia (BeO) and other oxide-system ceramics or aluminum nitride, silicon carbide and other non-oxide system ceramics. Other examples include, without limitation, low-temperature ceramics.

Prior to copper electroplating, the substrate material that is to be plated is subjected to a conductivization treatment carried out on the areas to be plated. For example, when metallic copper is used in order to fill the MVHs by means of the present electroplating process, the internal surfaces of the MVHs are first subjected to conductivization. The conductivization treatment used in the present invention can be any conventional conductivization method. Suitable examples of conductivization methods that can be cited include, but are not restricted to, electroless copper plating, direct plating, conductive microparticle adsorption treatment, and various other methods.

In the electrolytic plating method of the present invention, the plating temperature (solution temperature) is set appropriately in accordance with the type of plating bath used. Typically, the temperature is 10 to 40°C, with 20 to 30°C being preferred. While the temperature of the plating bath may be below 10°C, the conductivity of the plating liquid will decrease, and it will not be possible to increase the current density during electrolysis. A reduction in plated coating growth rate and productivity will result. If the plating temperature is too high, the brightening agents may decompose.

In the electrolytic copper plating process of the present invention, it is possible to use any type of current such as direct current or PPR (pulse periodic reverse) current. Although the positive electrode current density is to be set appropriately in accordance with the type of plating bath used, the current density is typically 0.1 to 10 A/dm², with 1 to 3 A/dm² being preferred.

With the electrolytic plating method of the present invention, any type of anode can be used such as soluble anodes or insoluble anodes. A phosphorus-containing copper anode is an example of a soluble anode. Examples of insoluble anodes include, but are not restricted to, indium oxide, platinum-clad titanium, platinum, graphite, ferrite, stainless steel or titanium coated with lead dioxide or platinum group element oxide and other materials.

In the plating method of the present invention, it is preferable to pass air or oxygen through the plating solution in order to increase the soluble oxygen concentration. While not wishing to be bound by theory, it is thought that the soluble oxygen in the plating solution functions as an oxidation agent, thereby decreasing the amount of compound having the -X-S structure in the plating solution. A method for increasing the soluble oxygen concentration in the plating solution preferably involves bubbling air or oxygen through the plating solution, but a configuration may be used in which said bubbling is carried out in conjunction with stirring of the plating solution. A configuration also may be used in which bubbling is carried out separately from stirring. Bubbling is carried out in order to increase the soluble oxygen concentration in the plating solution, and can be carried out during the electrolytic plating treatment, or during stoppage of the plating treatment.

Stirring is not necessary with the present plating method, but it is preferable for stirring to be carried out in order to provide more uniform supply of additives and copper ions to the surface of the material to be plated. The stirring method can be air stirring or a jet flow. From the standpoint of increasing the amount of soluble oxygen in the plating solution, it is desirable to perform stirring using air, and even when stirring is carried out using a jet flow, stirring by means of air can be employed in conjunction. Replacement filtration or circulation filtration can be carried out, and in particular, circulation filtration of the plating liquid using a filter is preferred, because the temperature of the plating liquid stabilized when this is done, and materials such as waste and precipitate present in the plating liquid can be removed.

The present electrolytic copper plating process provides composite materials containing of a copper layer on a substrate material. By carrying out the present plating process, it is possible to achieve gap-less filling of vias, without clumping in the resulting composite material copper layer.

The present invention is described below using working examples, but these working examples do not limit the scope of the present invention.

### Working Example

### Experimental methods

Process 1: 2 L of bath having the standard composition for via filling indicated below was prepared, and to this was added 1 mg/L of MPS, thus preparing a bath with artificially compromised via filling performance.

Process 2: 0.5 g/L of titanium oxide powder was added to the above bath with compromised via filling performance, and the powder was dispersed in the bath with a stirrer. The bath was then left for 5 h while being irradiated with ultraviolet light.

Process 3: A plating treatment was carried out by PPR electrolysis using the conditions described below.

Process 4: The filling condition was observed by a cross-sectioning method.

### Comparative Example 1

A plating treatment was carried out by PPR electrolysis immediately after process 1 described in the Working Example.

### Comparative Example 2

After process 1 described in the Working Example, the bath was left for 5 h, and subsequently, a plating treatment was carried out by PPR electrolysis.

| Composition of the bath for Process 1 | |
|---|---|
| CuSO₄·5H₂O | 130 g/L |
| H₂SO₄ | 190 g/L |
| Cl⁻ | 60 mg/L |
| SPS | 4 mg/L |
| Nonionic surfactant | 250 mg/L |
| MPS | 1 mg/L |
| Note: | |
| SPS: Disodium bis(3-sulfopropyl)disulfide | |
| MPS: Sodium 3-mercapto-1-propanesulfonate (available from Tokyo Kasei) | |
| Titanium oxide: Titanium (IV) oxide, anatase (available from Kanto Chemical; Grade 1, 0.5 g/L) | |
| Bath temperature: 23-37°C | |
| Ultraviolet lamp: Pencil-type/ output: 4 W | |
| Body: Velight Co., Model No. PS-2000-20 | |
| Primary voltage: 120 V, 60 Hz | |
| Lamp: Double Bore® lamp | |

### PPR electrolysis conditions

Current density: 2 A/dm²
Forward:reverse current density (F:R C.D.): 1:1
Forward/reverse pulse time (F/R P.T.): 10/0.5 (ms)
Temperature: 20°C
Time: 60 min
Via size: Via diameter 120 µm/depth 60 µm

### Results

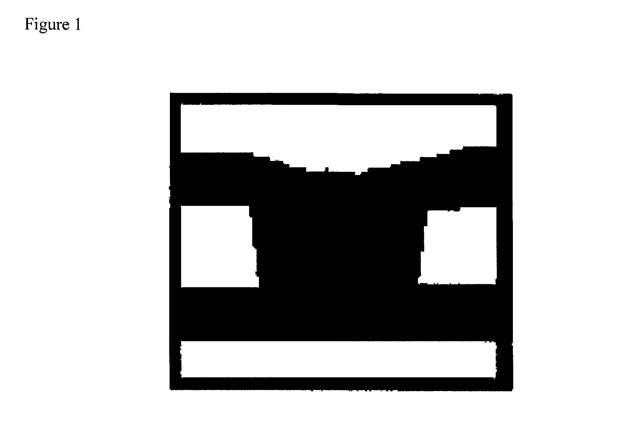

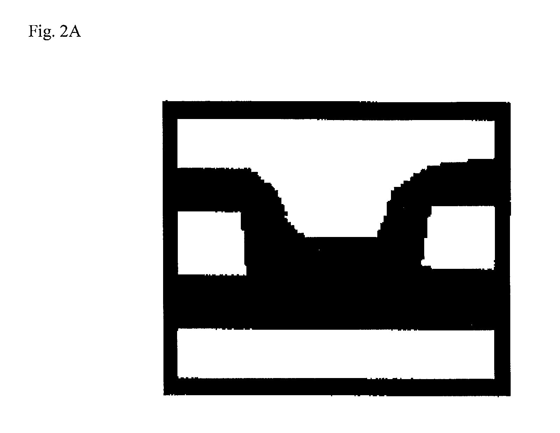

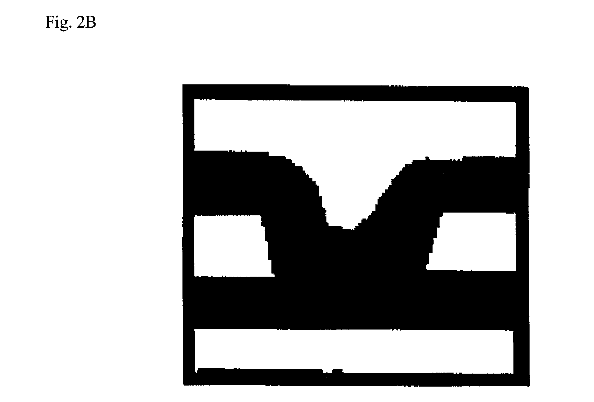

When the above processes were carried out using an evaluative substrate having 100 via holes, almost all of the 100 vias were well-filled in the Working Example. In Comparative Examples 1 and 2, on the other hand, most of the vias were not filled. A schematic diagram of the via cross-sections after treatment is shown in Figure 1 (Working Example) and in Figures 2A (Comparative Example 1) and 2B (Comparative Example 2). By means of the present invention, good via filling capacity was obtained, whereas filling was poor with Comparative Examples 1 and 2.

In the Working Example and in Comparative Example 2, the copper deposit in the filled vias exhibited good brightness, but in Comparative Example 1, a dull appearance was produced.

## Claims

1. A process for electrolytic copper plating comprising the steps of contacting a substrate to be plated with an electrolytic copper plating bath comprising a transition metal oxide and subjecting the plating bath to sufficient current density to deposit a layer of copper on the substrate.

2. The process according to claim 1 wherein the electrolytic copper plating bath further comprises copper sulfate.

3. The process of claim 1 further comprising the step of irradiating the electrolytic copper plating bath with ultraviolet or visible light

4. The process of claim 1 wherein the electrolytic copper plating bath further comprises a brightening agent having the structure -X-S-Y, wherein X and Y are independently selected from hydrogen, carbon, sulfur, nitrogen and oxygen, provided that X and Y are the same only when they are carbon.

5. The process of claim 1 wherein the substrate is a printed wiring board or a wafer.

6. The process of claim 1 wherein the substrate has one or more through-holes or via holes.

7. A copper plating bath composition suitable for electrolytic copper plating comprising a source of copper ions, an electrolyte, water and a transition metal oxide.

8. The composition of claim 8 wherein the transition metal oxide is titanium oxide.

9. The composition of claim 8 further comprising a brightening agent having the structure -X-S-Y, wherein X and Y are independently selected from hydrogen, carbon, sulfur, nitrogen and oxygen, provided that X and Y are the same only when they are carbon.
